## Europäisches Patentamt

## European Patent Office

## Office européen des brevets

(11) Veröffentlichungsnummer: **0 053 193**
**B1**

(12) # EUROPÄISCHE PATENTSCHRIFT

(45) Veröffentlichungstag der Patentschrift:
**17.04.85**

(51) Int. Cl.⁴: **H 03 M 1/78**

(21) Anmeldenummer: **80107406.3**

(22) Anmeldetag: **27.11.80**

(54) **Monolithisch integrierbares R-2R-Netzwerk.**

(43) Veröffentlichungstag der Anmeldung:
**09.06.82 Patentblatt 82/23**

(45) Bekanntmachung des Hinweises auf die Patenterteilung:
**17.04.85 Patentblatt 85/16**

(84) Benannte Vertragsstaaten:
**DE FR GB IT NL**

(56) Entgegenhaltungen:
**DE - A - 2 423 130**
**DE - A - 2 901 484**

(73) Patentinhaber: **Deutsche ITT Industries GmbH, Hans-Bunte-Strasse 19 Postfach 840, D-7800 Freiburg (DE)**

(84) Benannte Vertragsstaaten: **DE**

(73) Patentinhaber: **ITT INDUSTRIES INC., 320 Park Avenue, New York, NY 10022 (US)**

(84) Benannte Vertragsstaaten: **FR GB IT NL**

(72) Erfinder: **Struthoff, Holger, Ing.-grad., Am Märzengraben 2, D-7800 Freiburg (DE)**

(74) Vertreter: **Stutzer, Gerhard, Dr., Deutsche ITT Industries GmbH Patent- und Lizenzabteilung Hans-Bunte-Strasse 19 Postfach 840, D-7800 Freiburg (DE)**

## Beschreibung

Die Erfindung beschäftigt sich mit R-2R-Netzwerken, wie sie insbesondere für D/A-Wandler verwendet werden. Zum Stand der Technik wird in diesem Zusammenhang auf »Technische Informationen für die Industrie« Nr. 791221 »Digital/Analog-Wandler Grundlagen und Anwendungen« von Valvo (Dez. 1979) und die Zeitschrift »elektronikpraxis« Nr. 8 (Aug. 1979) Seiten 3 bis 16, verwiesen.

Bei der Verwendung solcher R-2R-Netzwerke in D/A-Wandlern werden elektronische Schalter verwendet, mit deren Hilfe jeder der 2R-Widerstände entsprechend einem digitalen Wort entweder an Masse oder an einen anderen Bezugspunkt gelegt werden kann. Der Bezugspunkt ist durch den Typ des D/A-Wandlers gegeben, wobei zwischen stromgesteuerten und spannungsgesteuerten D/A-Wandlern unterschieden wird.

Die Erfindung betrifft ein monolithisch integrierbares R-2R-Netzwerk mit einer Reihe von vor einem Abschlußwiderstand liegenden Serienwiderständen gemäß dem Oberbegriff des Anspruchs 1, wie es aus der DE-OS 2 901 484 und der DE-OS 2 423 130 bekannt ist. Bei diesen R-2R-Netzwerken sind die R-Längswiderstände durch die Quelle-Senke-Strecken von MOS-Transistoren gebildet, die stets im leitenden Zustand sind. Alle die den Widerstandswert 2R aufweisende Querwiderstände werden durch ein Paar von gleichen in Serie geschalteten MOS-Transistoren des Widerstandes R gebildet, die selbst als Schalter verwendet werden, um die einzelnen Knoten entweder an Masse oder an einen anderen Bezugspunkt zu legen. Diese Verwendung der in Form von MOS-Transistoren ausgebildeten Querwiderstände hat den Nachteil, daß die Schalterstrukturen der elektronischen Schalter durch den Widerstandswert 2R festgelegt sind und im Interesse kürzerer Schaltzeiten nicht verkleinert werden können.

Bei der Herstellung der elektronischen Schalter innerhalb einer monolithisch integrierten Festkörperschaltung unterliegen deren Schalterwiderstände Schwankungen infolge von Prozeßparameterschwankungen in der Produktion. Dies macht sich bei R-2R-Netzwerken unangenehm in der Genauigkeit bemerkbar.

Betrachtet man beispielsweise das R-2R-Netzwerk eines 8-Bit-D/A-Wandlers mit einer Genauigkeit von $\frac{1}{2}$ LSB (niedrigstwertiges Bit), so müssen schon hohe Anforderungen an die Serienwiderstände R und die 2R-Widerstände sowie an die Genauigkeit der Schaltwiderstände gestellt werden. Bei einem idealen R-2R-Netzwerk darf das Verhältnis $\frac{Rs}{2R}$ höchstens $\frac{1}{256}$ $\approx 0,004$ sein, wobei die absolute Schalterwicklerstandsschwankung $\pm 20\%$ betragen kann. Bei einem 2R-Widerstand von 8k Ohm erhält man dabei einen Schalterwiderstand von 32 Ohm. Ein Schalter mit einem derartig niedrigen Widerstand ist nur bei großflächiger Dimensionierung zu realisieren. Infolge der hohen Eingangskapazitäten erhält man nachteilige lange Schaltzeiten.

Aufgabe der Erfindung ist daher die Angabe eines monolithisch integrierbaren R-2R-Netzwerks eines D/A-Wandlers für kurze Schaltzeiten, bei dem die Auswirkungen der durch Prozeßparameterschwankungen gegebenen Schwankungen der Schaltwiderstände der elektronischen Schalter auf die Genauigkeit des Wandlers kompensiert sind.

Die vorstehend genannte Aufgabe wird erfindungsgemäß bei einem für einen monolithisch integrierten D/A-Wandler vorgesehenen monolithisch integrierbares R-2R-Netzwerk gemäß der im Oberbegriff des Anspruchs 1 genannten Art erfindungsgemäß durch die im kennzeichnenden Teils im Anspruch 1 angegebenen Ausbildung gelöst.

Unter als elektronische Schalter verwendbare gleichartige Schalterstrukturen sind solche Schalterstrukturen zu verstehen, welche vom gleichen Typ der elektronischen Schalter sind und deren die Kennlinien bestimmende Teile gleichzeitig mit denen der elektronischen Schalter hergestellt wurden. Bei Verwendung von Feldeffekttransistoren als elektronische Schalter sind also eine Feldeffekttransistorstruktur zu verwenden, deren Zonen und Gate-Elektrode einschließlich Gate-Oxidschicht gleichzeitig an bzw. in einem gemeinsamen Halbleiterkörper hergestellt werden. Gleiches gilt für bipolare Transistoren, insbesondere I²L-Transistoren, deren Zonen gleichzeitig in einen Halbleiterkörper zusammen mit den Zonen einer gleichartig aufgebauten I²L-Schalterstruktur in die Oberfläche eines gemeinsamen Halbleiterkörpers eindiffundiert werden.

Die Genauigkeit eines Wandlers, in welchem ein R-2R-Netzwerk nach der Erfindung verwendet wird, wird zunächst dadurch verbessert, daß der Widerstand der Schalterstrukturen halb so groß gewählt wird wie der Einschaltwiderstand der elektronischen Schalter. In diesem Falle gehen nämlich die Schwankungen der Schalterwiderstände relativ zu den Längswiderständen der Schalterstrukturen im gleichen Widerstansverhältnis wie das der mit ihnen verbundenen Widerstände ein.

Eine weitere wesentliche Verbesserung in Richtung auf die Kompensation der nachteiligen Auswirkungen der Prozeßparameterschwankungen wird dadurch erzielt, daß der eine Anschluß der beiden elektronischen Schalter jeweils mit dem zugehörigen Knoten verbunden ist und daß in Reihe zu jedem der elektronischen Schalter je ein 2R-Widerstand liegt. In diesem Falle liegen nämlich die gleichartigen Anschlüsse, nämlich die Source-Elektroden bei einer Verwendung von Feldeffekttransistoren und Feldeffekttransistorstrukturen bzw. Emitter-Elektroden bei einer Verwendung von bipolaren Transistoren und bipolaren Transistorstrukturen, auf gleichem Potential. Damit ergibt sich die gleiche Kompensation der Schwankungen der Einschaltwiderstände bei den Schalterstrukturen und den elektronischen Schaltern, da diese Einschaltwiderstände in guter Nährung umgekehrt proportional dem Produkt aus dem $\beta$-Wert und der Differenz aus der Spannung zwischen den Knotenpunkt und der Schwellspannung ist.

Die Erfindung wird im folgenden anhand der Zeichnung erläutert

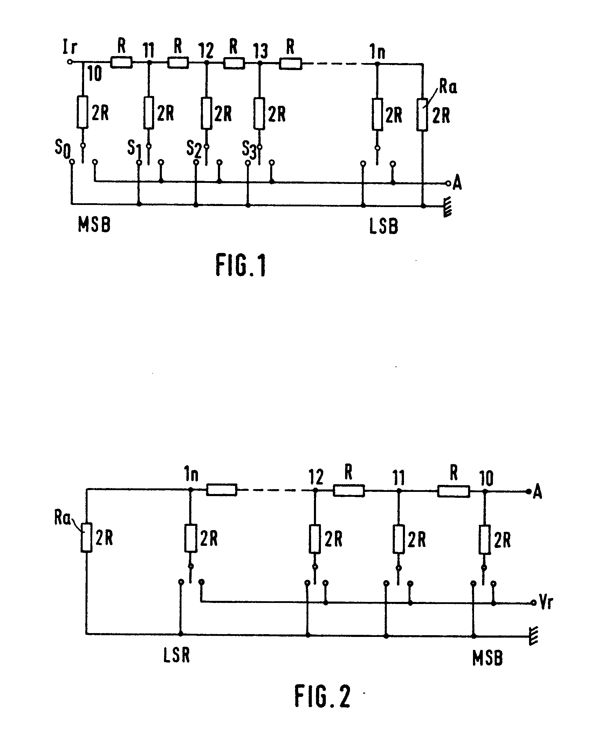

deren Fig. 1 schematisch ein stromgesteuertes R-2R-Netzwerk zeigt,

deren Fig. 2 schematisch ein spannungsgesteuertes R-2R-Netzwerk veranschaulicht,

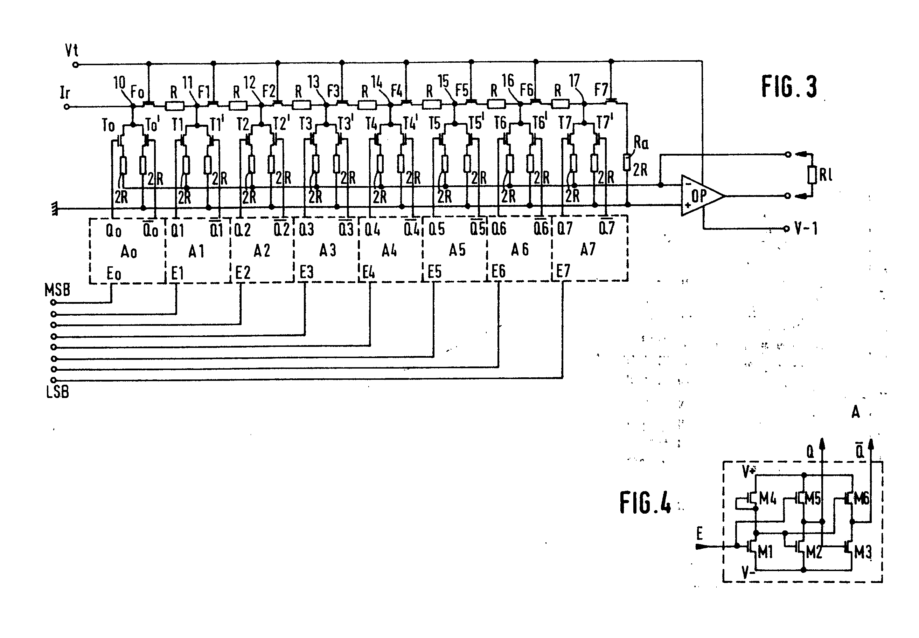

deren Fig. 3 die Schaltung eines D/A-Wandlers mit einem R-2R-Netzwerk nach der Erfindung mit Feldeffekttransistoren als elektronischer Schalter und gleichartige Schalterstrukturen zeigt und

deren Fig. 4 die Schaltung der Eingangsgatter A des D/A-Wandlers nach der Fig. 3 enthält.

Die Erfindung kann sowohl bei dem stromgesteuerten R-2R-Netzwerk nach der Fig. 1, als auch bei dem spannungsgesteuerten R-2R-Netzwerk nach der Fig. 2 angewendet werden. Während bei dem stromgesteuerten R-2R-Netzwerk der eine Anschluß der einzelnen 2R-Widerstände zwischen Masse und dem Ausgang A schaltbar ist, ist dieser eine Anschluß der einzelnen 2R-Widerstände beim spannungsgesteuerten R-2R-Netzwerk nach der Fig. 2 zwischen Masse und der Bezugsspannung Vr umschaltbar. Beide Netzwerke weisen den Abschlußwiderstand Ra am Ende der Serienwiderstände gegen Masse auf, der im allgemeinen den gleichen Wert erhält, wie die 2R-Widerstände. Das stromgesteuerte R-2R-Netzwerk nach der Fig. 1 erhält seinen Referenzstrom Ir an dem dem Abschlußwiderstand Ra abgelegenen Ende der in Reihe geschalteten Serienwiderstände R. Dagegen wird an diesem dem Abschlußwiderstand Ra abgelegenen Ende der Reihenschaltung der Serienwiderstände R beim spannungsgesteuerten R-2R-Netzwerk der Fig. 2 das Ausgangssignal am Ausgang A abgenommen.

Die Fig. 3 zeigt das Schaltbild eines D/A-Wandlers, in welchem ein R-2R-Netzwerk nach der Erfindung mit Isolierschicht-Feldeffekttransistoren To, To' ... T7, T7' als elektronische Schalter verwendet werden. Diese werden mit den Feldeffekttransistorstrukturen Fo ... F7 gleichzeitig in die bzw. an der Oberflächenseite eines plattenförmigen Halbleitersubstrats hergestellt. Dies bedeutet, daß gleichzeitig die Zonen (Source- und Drain-Zonen) und während der gleichen Prozesse die Gate-Elektroden einschließlich der Gate-Isolatorschicht hergestellt werden. In weiteren Prozessen werden die Serienwiderstände R und die 2R-Widerstände vorzugsweise durch Ionenimplantation und anschließender Temperung hergestellt und die Zwischenverbindungen entsprechend der Fig. 3 anschließend an die Zonen und Elektroden angebracht. Dabei werden die Gate-Elektroden der Schalterstrukturen Fo ... F7 an einen gemeinsamen Schaltungspunkt geführt, so daß diese an ein festes Potential gelegt werden können, so daß die Schalterstrukturen sich ständig im elektrisch leitenden Zustand befinden.

Bei der Auslegung der Feldeffekttransistoren To ... T7' und der Feldeffekttransistorstrukturen Fo ... F7 wird ein Verhältnis der $\beta$-Werte (W/L-Verhältnis) derart gewählt, daß die $\beta$-Werte der Feldeffekttransistoren To bis T7' halb so groß sind wie die der Feldeffekttransistorstrukturen Fo bis F7 und somit der Widerstand jeder dieser Strukturen die Hälfte des Einschaltwiderstandes der einzelnen Feldeffekttransistoren To bis T7' beträgt.

An jedem Knoten liegen gemäß der Fig. 3 je drei Source-Elektroden sowohl der Feldeffekttransistoren T als auch der Feldeffekttransistorstrukturen F. Dies bedeutet, daß die Schwankungen der Einschaltwiderstände bei der Herstellung in monolithisch integrierter Form optimal kompensiert sind. Je eine der Elektroden der Feldeffekttransistorpaare To, To' ... T7 und T7' sind über je einen 2R-Widerstand mit einem Anschluß des Operationsverstärkers OP verbunden, der bei einem Wandler mit Stromausgang entfällt. Dieser weist zwischen dem Ausgang und dem nicht auf Massepotential liegenden Eingang den Eichwiderstand Rl auf.

Die Gate-Elektroden eines Paares von Feldeffekttransistoren werden bitweise an die beiden Ausgänge Qo, Qo' ... Q7, Q7' der Eingangsgatter Ao ... A7 angelegt, an deren Eingänge Eo ... E7 je ein Bit eines 8-Bit-Wortes ansteht.

Die Fig. 4 zeigt das Schaltbild eines solchen Eingangsgatters,- welches mit n-Kanal-Feldeffekttransistoren ausgeführt ist und eingangsseitig den aus dem Transistoren M1 und M4 bestehenden Inverter enthält. Dessen Ausgang ist einerseits mit dem substratseitig liegenden Transistor M2 eines aus der Reihenschaltung zweier Feldeffekttransistoren M2 und M5 bestehenden zweiten Inverters und andererseits mit der Gate-Elektrode des mit der Drain-Elektrode an der Versorgungsspannung V+ liegenden zweiten Inverters mit einer Reihenschaltung aus den beiden Transistoren M3 und M6 verbunden. Der Eingang E des Eingangsgatters A liegt ferner an der Drain-Elektrode des mit der Drain-Elektrode an der Versorgungsspannung V+ liegenden Isolierschicht-Feldeffekttransistors M5. Die zueinander komplementären Ausgangssignale Q und Q' werden an je einem der gemeinsamen Verbindungspunkte der beiden Transistoren des zweiten Inverters M2, M5 und des dritten Inverters M3, M6 abgegriffen.

Die Erfindung hat nicht nur den Vorteil einer weitestgehenden Kompensation der Auswirkungen von Prozeßparameterschwankungen auf die Halbleiterplatten die gleichzeitig den erforderlichen Herstellungsprozessen unterworfen werden, so daß nur die wesentlich geringeren Schwankungen über die einzelnen Platten in das Ergebnis eingehen. Darüberhinaus können auch Schalterstrukturen kleinerer Abmessungen verwendet werden, da die relativen Schwankungen der Strukturen des R-2R-Netzwerks nach der Erfindung bedeutend kleiner als bei herkömmlichen R-2R-Netzwerken sind. Damit wird aber auch die Realisierung von D/A-Wandlern mit kürzeren Schaltzeiten möglich.

## Patentansprüche

1. Monolithisch integrierbares R-2R-Netzwerk mit einer Reihe von vor einem Abschlußwiderstand liegenden Serienwiderständen, wobei an die Knoten zwischen den Serienwiderständen, an den Knoten zwischen dem Abschlußwiderstand und dem letzten Widerstand der Reihe und einem Knoten vor dem ersten Serienwiderstand je eine 2R-Widerstandseinheit an Masse oder an einem anderen Bezugspunkt schaltbar ist, dadurch gekennzeichnet,

— daß jeder der Knoten (10, 11, . . ., 16, 17) mit je einem Anschluß eines Paares von zwei zueinander parallelen elektronischen Schaltern (To, To'; . . . T7, T7'), die in Reihe zu je einem der 2R-Widerstände liegen, verbunden ist, über welche 2R-Widerstände der zugehörige Knoten entweder an Masse oder an einen anderen Bezugspunkt schaltbar ist,
— daß jeder der Knoten (10, 11, . . ., 16) bis auf den letzten Knoten (17) über eine hinsichtlich der beiden elektronischen Schalter (To, To'; . . .; T7, T7') gleichartige Schalterstruktur (F1, . . . F6), welche sich ständig im elektrisch leitenden Zustand befindet, und über einen der Serienwiderstände (R) mit dem nächsten Knoten und der letzte Knoten (17) über eine solche Schalterstruktur (F7) mit dem Abschlußwiderstand (Ra) verbunden ist und
— daß der Widerstand jeder der Schalterstrukturen (F1, . . ., F7) die Hälfte des Einschaltwiderstandes der einzelnen elektronischen Schalter (To, To; . . .; T7, T7') beträgt.

2. Monolithisch integrierbares R-2R-Netzwerk nach dem Anspruch 1, dadurch gekennzeichnet, daß als elektronische Schalter (To . . . T7') Transistoren und als Schalterstrukturen (Fo . . ., F7) gleichartige Transitorstrukturen verwendet werden.

## Claims

1. Monolithic integrable R-2R-network comprising a number of series resistors arranged ahead of a terminal resistor wherein to the nodes between the series resistors, to the node between the terminal resistor and the last resistor of the series, and to a node ahead of the first series resistor, one 2R resistor unit is capable of being connected either to ground or to another reference point, characterized in

— that each of the nodes (10, 11, . . . 16, 17) is connected to one terminal each of a pair of two electronic switches (To, To'; . . . T7, T7') being arranged in parallel which are connected in series to one of said 2R resistors across which 2R resistors the associated node is capable of being switched either to ground or to another reference point,
— that each of said nodes (10, 11, . . . 16) with the exception of the last node (17) is connected across a switch structure which with respect to the two electronic switches are of the same kind and which are permanently in the electrically conducting state, and across one of the series resistors (R) to the next node and the last node (17) across such a switch structure (F7) to the terminal resistor (Ra) and
— that the resistance of each of said switch structures (F1, . . ., F7) amounts to one half of the turn-on resistance of each of said electronic switches (To, To'; . . .; T7, T7').

2. A monolothic integrable R-2R-network as claimed in Claim 1, characterized in that as electronic switches (To . . . T7') there are used transistors and that as switch structures ( Fo . . . F7) there are used transistor structures of the same kind.

## Revendications

1. Réseau R-2R-monolithiquement intégrable, comprenant une chaîne de résistances connectées en série, située en amont d'une résistance terminale, dans lequel, aux noeuds entre les résistances série, au noeud entre la résistance terminale et la dernière résistance de la chaîne et à un noeud en amont de la première résistance série, est associée à chaque fois une unité de résistance 2R, prévue pour être connectée à la masse ou à un autre point de référence, caractérisé

— en ce que chacun des noeuds (10, 11 . . ., 16, 17) est en liaison, avec à chaque fois une borne d'une paire de deux interrupteurs électroniques mutuellement en parallèle (To, To' . . .; T7, T7') qui sont en série chacun avec l'une des résistances 2R, lesdites résistances étant intercalées dans les trajets par lesquels le noeud associé peut être relié soit à la masse soit à un autre point de référence;
— en ce que chacun des noeuds (10, 11 . . ., 16), à l'exception du dernier noeud (17), est relié au noeud suivant, via une structure de commutateur (F1 . . . F6), du même genre que celles des deux interrupteurs électroniques (To, To' . . .; T7, T7'), laquelle se trouve constamment en état de conduction électrique, et via l'une des résistances série (R), le dernier noeud (17) étant relié, via une telle structure de commutateur (F7), à la résistance terminale (Ra); et

— en ce que la résistance de chacune des structures de commutateur (F1 ..., F7) a une valeur égale à la moitié de la résistance d'insertion des interrupteurs électroniques individuels (To, To' ...; T7, T7').

2. Réseau R-2R monolithiquement intégrable selon la revendication 1, caractérisé en ce que l'on utilise, comme interrupteurs électroniques (To ..., T7'), des transistors et, comme structures de commutateur (Fo ..., F7), des structures de transistor du même genre.

FIG.1

FIG.2

FIG. 3

FIG. 4